# EUROPEAN PATENT APPLICATION

(11) **EP 1 072 954 A2**
(43) Date of publication of application: **31.01.2001**
(21) Application number: 00306047.2
(22) Date of filing: 17.07.2000
(51) Int. Cl.: G03F 7/00

(54) **Lithographic process for device fabrication**

(30) Priority: 28.07.1999 US 362424
(71) Applicant: LUCENT TECHNOLOGIES INC., Murray Hill, New Jersey 07974-0636 (US)
(72) Inventor: Prybyla, Judith Ann, Edison, New Jersey 08820 (US); Rogers, John A., New Providence, New Jersey 07974 (US)
(74) Representative: Buckley, Christopher Simon Thirsk

(57) **Abstract**

A lithographic process in which a flexible mold (20) is used to introduce a pattern into a layer of material (15) formed on a semiconductor substrate (10) is disclosed. The flexible mold has a surface with at least one protruding surface (21) and at least one recessed surface that cooperate to define a pattern. In the process, the layer of material (15) is formed on a substrate (10). The mold surface is placed in contact with the material with sufficient force to transfer the pattern in the mold surface into the resist material. A rigid, flat surface (25) is placed in contact with the flexible mold on a side of the mold opposite the patterned mold surface. The rigid surface causes each region of a particular thickness in the molded material to be substantially planar. The resist material is hardened while in contact with mold surface and while the mold is in contact with the flat surface. After the material is hardened, the mold is separated from the hardened material. The patterned material is then used in subsequent processing.

## Description

### BACKGROUND OF THE INVENTION

### TECHNICAL FIELD

The invention is directed to a lithographic process for device fabrication in which a mold is used to delineate a pattern in an energy sensitive resist material.

### ART BACKGROUND

Devices such as integrated circuits are complex structures made of a variety of materials. These materials are precisely configured to form the desired device by a variety of processes. A lithographic process is frequently used to transfer the desired configuration into a substrate (or a thin film carried on a substrate) to fabricate such devices.

Lithographic processes use intermediate energy sensitive materials referred to as resists. A positive or negative image of the desired configuration is first introduced into the resist by exposing it to patterned radiation that induces a chemical change in the exposed portions of the resist. The radiation is electron beam, ion beam or a beam of light. The radiation is patterned either by a blanket exposure of a mask or reticle or by scanning a focused beam. This chemical change is then exploited to develop a pattern in the resist, which is then transferred into the substrate underlying the resist.

Currently, there is a need to increase the number of devices on a single substrate. To meet this need, individual devices are being made smaller. To make smaller devices, the pattern features that define the devices must also become finer. Currently, patterns with features smaller than 50 nm are needed. Although electron beam lithography and x-ray lithography provide sub 50-nm resolution of features, the lithographic tools needed to practice such techniques are expensive.

One inexpensive alternative to optical lithographic processes that are used to create patterns with feature sizes less than 50 nm is the compressive molding process described in U.S. Patent No. 5,772,905 to Chou et al. In this technique, a layer of thin film is deposited on the surface of a substrate. A rigid mold having at least one protruding feature is used to define a pattern in the film. The film and mold are then heated above the glass transition temperature of the film, and the mold and film are compressed together at high (e.g. 1900 psi) pressure. The mold and film are compressed together at this temperature until the temperature of the film drops below the glass transition temperature. The thickness of the film under the protruding feature is thinner than the thickness of the film under the recess. The mold is then removed from contact with the film. The thin film is then processed so that the thinner portions are removed, exposing the surface of the substrate underneath them. The thicker portions of the film remain on the substrate. The resulting surface thereby replicates the pattern in the mold.

Other molding techniques for forming patterns with nanometer-sized features, such as the technique described in Xia, Y. et al., "Replica Molding Using Polymeric Materials: A Practical Step Toward Nanomanufacturing," Adv. Mater., Vol. 9, p. 147 (1997), employ a photocurable material as the molded material. In such processes, the molded material has a viscosity that is sufficiently low, without being heated, to conform to the pattern in the mold when the mold is placed in contact with the material. After the mold is placed in contact with the material, the material is cured (i.e. hardened) using radiation such as a beam of light. However, Xia et al. observed that the development of new technologies would be required before nanostructures produced by their process could be used to generate functional electronic or optical components. Consequently, although processes that employ a mold to pattern nanometer-sized features in a thin film remain attractive as a low-cost processing alternative to more expensive lithographic techniques, further improvement is required.

### SUMMARY OF THE INVENTION

The present invention is a process for device fabrication. In the process of the present invention a pattern is introduced into a layer of material using an object with a flat surface in conjunction with a flexible mold that defines a pattern. The mold is an article with a relief surface. The relief surface has at least one patterning region. The patterning region has at least one projection and at least one recess. When the mold is placed in contact with the material, the surface of the material conforms to the mold relief surface. The at least one projection on the mold relief surface defines a region in the material that is thinner than the region defined by the at least one recess in the mold relief surface. Thus, the pattern defined in the material is delineated by regions of different thicknesses, and these different thicknesses are introduced by the mold relief surface. It is advantageous if the relief surface also has a planarizing region. The planarizing region introduces a desired flatness to the portion of the surface of the material that is not patterned by the mold relief surface.

The mold is formed by patterning the surface of a mold substrate or by casting a liquid precursor of mold material over a patterned surface and then solidifying the material. The planarizing region of the mold has a substantially uniform thickness (the thickness being the distance from the planarizing surface to the back surface (i.e. the surface opposite the relief surface)). It is advantageous if the plane defined by the mold surface opposite to the relief surface and the planes defined by projection(s) and recess(es) in the mold relief are all substantially parallel to each other.

The mold cooperates with the object having a flat surface to provide a desired planarity in the pattern defined in the material. Since the pattern transferred from the mold relief surface to the surface of the material is a relief surface, the molded surface has regions in different planes. For example, for a pattern defined by one thin region and one thick region, the thin region is in a first plane and the thick region is in a second plane. It is advantageous if the regions in the first plane are substantially planar with each other. It is additionally also advantageous if the regions in the second plane are substantially planar with each other.

In the process, the layer of material is formed on a substrate. The substrate is typically a semiconductor substrate (e.g. silicon, silicon-germanium, silicon-on-insulator). In addition to fabrication of devices for microelectronics, where semiconductor substrates are commonly used, high resolution lithography is useful for patterning of organic electronics, diffractive optics, disks for magnetic and optical storage, microfluidic total analysis systems and other applications where substrates can include plastic sheets, quartz plates and metallic phase-change media. The substrate either is a bare semiconductor substrate or, more typically, one or more layers of material formed on a semiconductor substrate. In one embodiment of the present invention, the surface on which the material is applied is a topographic surface. After the layer of material is formed on the substrate, it is placed in contact with a mold. The mold surface has a planarizing region and a relief pattern region. The relief pattern region has at least one protrusion and one recess. The mold is also substantially flexible. In the context of the present invention, a mold is substantially flexible when it deforms in response to a pressure of less than about 10 psi (including materials that deform under their own weight).

Because the mold is substantially flexible, it will deform in response to the application of a small force Since deformation during the molding process is not desirable, the mold is backed by a flat surface when the mold relief pattern is placed in contact with the material. The flat surface is more rigid than the substrate. Because the flat surface is more rigid than such substrate, the substrate itself flattens in response to pressured contact from the mold backed by the flat surface. For example, silicon wafers have a tendency to warp. Such warpage can adversely affect planarity. In the present process, wafer warpage is eliminated when the surface of the material is molded. If the substrate does not have a tendency to warp, then it is advantageous if the flat surface is at least about as rigid as the substrate on which the layer of material is formed.

Objects with sufficiently flat surfaces for use in the present process are well known to one skilled in the art. One example of such an object is a thick (e.g. 1.5 inches thick for a nine-inch diameter) optical flat made of fused silica. The optical flat has a surface flatness of λ/10, where λ is the wavelength of a standard sodium lamp, and less than about 50 angstroms RMS (root means squared) microroughness.

The relief pattern is placed in contact with the layer of material with sufficient force to transfer the pattern into the layer of material. This pattern transfer is accomplished either before or after the flat surface is placed in contact with the mold. In this regard, the material must yield or flow in response to the pressured contact of the mold surface in a manner that permits the mold to be imprinted into the material. Suitable materials are energy-curable materials (materials that harden or cure in response to energy) or materials that soften when heated. The material is then hardened. In one embodiment of the present invention, the material is an energy-curable material that is hardened by exposure to radiation. In another embodiment of the present invention, the material is hardened by thermal curing. In another embodiment, the material is melted, patterned and cooled (to reharden it).

After the molded material is hardened, the mold is removed from contact with the hardened material. First, the rigid, flat surface is removed from contact with the mold. Then the mold is removed from contact with the solidified material. Because the mold itself is deformable, it is easily separated from contact with the hardened material without damaging the pattern in the hardened material. In this regard, the mold material is selected so that it will not adhere to the hardened material. One skilled in the art will readily select an appropriate material. Also, a release agent may be used to ensure that the mold and the material do not adhere to each other.

Also, because of the flexible nature of the mold (and the thickness uniformity that derives from the fact that the planarizing region of the mold is of substantially uniform thickness), the planarity of the planarizing region is transferred through the mold and into the material. Unwanted topography that might otherwise result is avoided because the flat surface is oriented to be substantially parallel to the desired planar region on the molded surface. Consequently, the flat surface ensures the integrity of the pattern transfer of the mold relief surface into the molded material. Unwanted topography that might otherwise result from mold deformation or misalignment is not introduced into the layer of molded material due to the cooperation of the flat surface and the substantially flexible mold. In this regard the present invention is also useful to introduce a pattern with no planarizing region (e.g. a sinusoidal surface) in the material.

After the mold is removed from contact with the hardened material, the hardened material is processed so that the thinner portions of the hardened material are removed, exposing the underlying substrate. Thus, the pattern in the mold is replicated in the film of hardened material. In certain embodiments, the patterned material is etched so that the thin portions of the patterned layer are removed, exposing the underlying portion of the substrate surface. The pattern in the film of hardened material is, in subsequent processing, transferred into the underlying substrate. In another embodiment, a layer of material is deposited over the patterned film of hardened material. The over-deposited layer is then patterned by lift-off of the underlying patterned film.

### BRIEF DESCRIPTION OF THE DRAWINGS

FIG. 1A is a cross sectional view showing a mold, substrate and flat surface in accordance with the present invention.
FIG. 1B is a cross sectional view of the mold and substrate of FIG. 1A showing the mold applied to a thin film of energy-curable material formed on the substrate.
FIG. 1C is a cross-sectional view of the substrate of FIG. 1B with the mold in full contact with the thin film.
FIG. 1D is a cross-sectional view of the substrate of FIG. 1C showing the rigid, flat surface pressed into contact with the back of the flexible mold.
FIG. 1E is a cross-sectional view of the substrate of FIG. 1D in which the energy-curable material is exposed to radiation while in contact with the mold.
FIG. 1F is a cross-sectional view of the substrate of FIG. 1E, in which the mold is being removed from contact with the hardened, underlying material.
FIG. 1G is a cross-sectional view of the substrate of FIG. 1F showing removal of the thin portions of the energy-curable film to expose the underlying substrate.
FIG. 2 is an exploded, cross-sectional view of an apparatus suitable for placing the mold in contact with the energy-curable material and compressing them together.

### DETAILED DESCRIPTION

The present invention is further described in terms of specific examples. These examples are provided to further illustrate the invention. These examples are not intended to circumscribe the scope of the present invention.

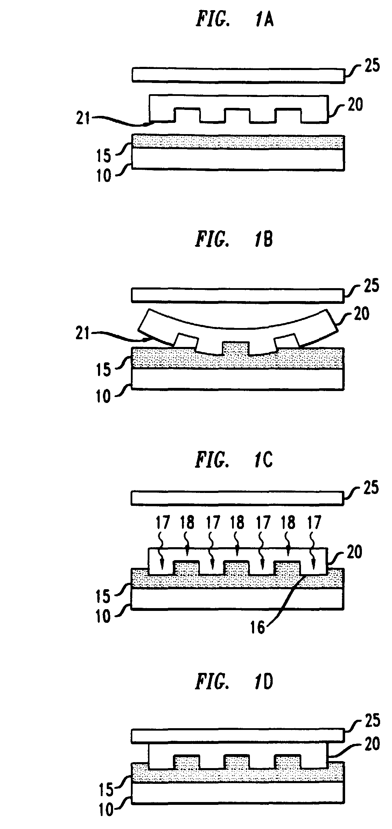

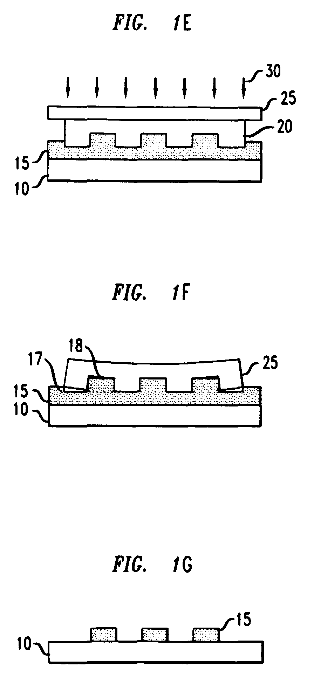

The process of the present invention is described in terms of an exemplary process flow illustrated in FIGS. 1A-1G. These FIGS. are not to scale. Referring to FIG. 1, a thin film of a liquid, energy-curable material 15 is formed on a substrate 10. The substrate 10 is a semiconductor substrate such as a silicon wafer. In certain embodiments, the substrate has one or more layers of other material formed thereon. Examples of these other materials include insulators (e.g. silicon dioxide (SiO₂), silicon nitride) and metals (e.g., aluminum, copper, tungsten, gold).

A mold 20 with a relief pattern 21 is provided. The mold material is selected to provide a mold with certain characteristics. One characteristic is that the mold be substantially flexible. That is, the mold bends with the application of a small amount of pressure ( not more than about 10 psi should be required to bend the mold). Another characteristic is that the mold be transparent to the radiation that is used to harden or cure the energy-curable material. This characteristic is advantageous when the energy-curable material is a radiation-curable material. This characteristic provides no advantage if the energy-curable material is a heat-curable material.

A substantially flexible mold has the capability to at least slightly deform when either placed in contact with or removed from contact with the molded material. This permits the mold to be placed in contact with or separated from the molded material incrementally instead of globally. Incremental contact is when one portion of the mold contact surface is in contact with the energy-curable material and one portion is not. Global contact is when the entire mold contact surface is placed into contact with, or removed from contact with, the energy-curable material at the same time.

Using a substantially flexible mold is advantageous when the mold is brought into contact with the energy-curable material because air that would otherwise be trapped between the mold surface and the material is allowed to escape as incremental contact progresses (either from the middle of the mold moving outward or from one side of the mold to the other). The substantially flexible mold is also advantageous when the mold is removed from contact with the hardened, energy-curable material. The advantage derives from the fact that less force is required to incrementally separate the mold from the hardened material compared to the amount of force required for global separation. Consequently, the hardened material is subjected to less force during incremental separation from the mold compared to global separation from the mold. The pattern in the hardened material is less likely to be damaged during incremental separation compared to global separation.

If the mold and the energy-curable material are both rigid (as is the case in the previously cited patent to Chou et al.) then global separation is required to separate the mold and the hardened material. This limits the patterned area of the molded surface, because the force required to separate large surface areas (e.g. the surface area of a six-inch or eight-inch silicon wafer) is likely to damage the molded pattern.

One example of a suitable mold material is an elastomer of polydimethylsioxane. A mold of such a material can be prepared by a variety of techniques well known to one skilled in the art. In one exemplary technique a pattern is formed in an energy sensitive material (referred to as a resist) using high-resolution lithography. The resist is either positive tone or negative tone and is formed on a rigid substrate.

Patterns with features as small as 20 nm are formed using high-resolution lithography. Patterning features with a dimension as small as 5 nm is achievable using the process of the present invention. The process conditions and materials used in high-resolution lithography are well known to one skilled in the art and are not discussed in detail herein.

After the image of the pattern is delineated in the resist, the pattern is developed. A liquid precursor of the mold material is then cast over the patterned resist material. The liquid precursor is then cured (hardened) and is separated from the resist pattern.

Since the mold is flexible, it is advantageous if it is backed by a substantially rigid surface when placed in contact with the energy-curable material 15. In the context of the present invention, substantially rigid is more rigid than the substrate on which the layer of energy-curable material is formed. In FIG. 1A, the flat, rigid surface, 25, is not yet in contact with the mold 20.

Referring to FIG. 1B, the mold 20 is incrementally placed in contact with the energy-curable material 15. Incremental contact is illustrated in FIG. 1B. In incremental contact the mold surface and the surface of energy-curable material are not co-planar when first placed in contact with each other. The mold 20 is dished as it is brought into contact with the energy-curable material 15. Consequently, air between the mold 20 and the energy-curable material 15 is permitted to escape. This provides an advantage over prior art rigid molds, where air is likely to be trapped between the mold and energy-curable material as they are brought into contact. Air so trapped can cause the subsequent molded surface to be non-uniform.

Referring to FIG. 1C, when the mold 20 is pressed slightly into the energy-curable material 15, the energy-curable material 15 conforms to the patterned mold surface 21. The energy-curable material that is displaced by the projections in the patterned mold surface 21 flows into the recesses in patterned mold surface 21.

Referring to FIG. 1D, the rigid, flat surface 25 is then brought into contact with the mold 20. The rigid flat surface 25 is oriented to be substantially parallel to the surface of substrate 10. The rigid, flat surface imparts a planarized region and a patterned region to the molded surface of the energy-curable material 15. Referring to FIG. 1E, the energy-curable material is hardened by exposing it to radiation 30. The wavelength of the exposing radiation depends upon the particular material. Both the flat surface 25 and the mold 20 are substantially transparent at the wavelength of the exposing radiation.

Referring to FIG. 1F, after the energy-curable material is hardened and the rigid, flat surface is removed from contact with the mold 25, the mold 25 is separated from the hardened material 15. The hardened material is then etched until the thin regions 17 of the material are removed, exposing the surface of the substrate 10. As illustrated in FIG. 1G, the remaining portions of the hardened material 15 correspond to the thicker portions 18 of the layer of hardened material 15 in FIG. 1F.

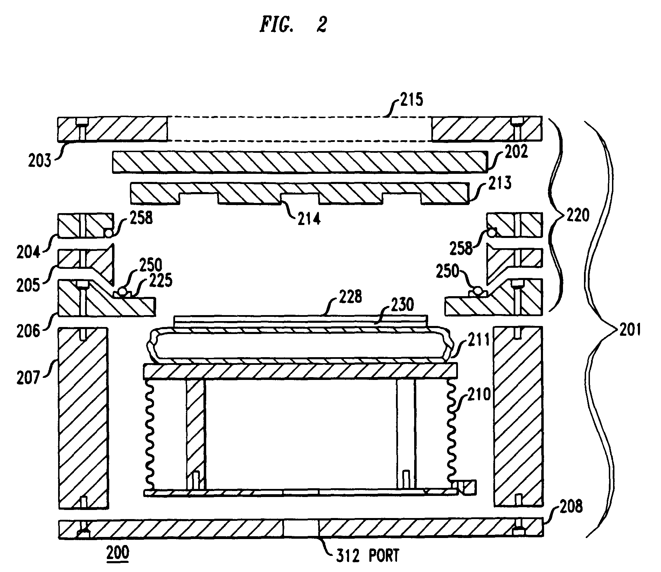

FIG. 2 (not to scale) is a schematic of a tool 200 that is used to bring the flat surface of an object 202 into contact with a mold 213 with a relief surface 214. The apparatus also brings the relief surface 214 into contact with the energy-curable material 228. The tool 200 has a housing 201, within which is engaged an object 202 with a flat surface and a mold 213. A substrate 230 with a layer of energy-curable material 228 thereon is set upon a deformable support 211 which is movably engaged in the housing 201. Thus, the deformable support 211, can be moved from a first position, in which the energy-curable material 228 is not in contact with the relief surface 214 of the mold 213, to a second position, in which the energy-curable material 228 is in contact with the relief surface 214 of the mold 213.

One example of an object 202 with a flat surface that is both sufficiently rigid and sufficiently planar is an optical flat. Also, it is advantageous for the object to be transparent to ultraviolet radiation, since in certain embodiments, the energy-curable material is hardened when exposed to such radiation. One example of an object which provides a desirably flat surface is an optical flat made of fused silica available from General Optics, Moorpark, California. The shape of object 202 is variable as are its dimensions. However, the object 202 has a sufficient thickness to ensure that each planarized region formed in the energy-curable material 228 has the desired degree of planarity.

Housing 201 incorporates a multi-component lid assembly 220 including a lower lid 206, a middle lid 205, an upper lid 204, and a clamping lid 203, for securing object 202 to housing 201. The lower surface of object 202 rests on o-ring 250 situated on lip 225 of lower lid 206. O-ring 250 forms a seal with object 202 when housing 201 is evacuated, as discussed below. Upper lid 204 and middle lid 205, in combination with o-ring 258, are configured to restrain object 202 from lateral movement, when secured in lid assembly 220. Lower lid 206, shown in FIG. 3, is depicted as a ring of material, however the shape of lower lid 206 is a matter of design choice and any configuration which performs the function of restraining the object 202, securing a vacuum (as discussed below), and permitting contact of the object 202, mold 213 and energy-curable material 228, is contemplated as suitable.

Middle lid 205 and upper lid 204, conforming to the shape and thickness of object 202, are attached to lower lid 206. It is advantageous for the top surface of object 202 to be in the same plane as the top surface of upper lid 204, so the attachment of clamping lid 203 to upper lid 204 limits the vertical movement of object 202 when the energy-curable material 228 on the substrate 230 contacts the mold relief surface 214. Top clamp ring 203 includes a region 215, through which radiation is transmitted onto the surface of the energy-definable material 228 on the substrate 230. The radiation is used to cure the energy-curable material 228 formed over the substrate surface (as discussed below). For example, as shown in FIG. 3, region 215 is preferably an open region of clamping lid 203, which permits the transmission of energy therethrough.

The multicomponent lid assembly 220 is attached to the housing sidewalls 207 using binges (not shown) and/or a plurality of clamps and bolts (not shown). The hinges and/or clamps and bolts (not shown) facilitate the loading and unloading of substrates 230 from planarization tool 200. The component parts of housing 201, except as discussed above, are preferably constructed of a metal such as, for example, aluminum.

### EXAMPLE 1

A mold was formed by depositing a layer of resist material (a novolac resin, Shipley 1805, obtained from the Shipley Company of Marlborough Mass.) on a silicon wafer with a 2 µm thick layer of silicon oxide formed thereon. The thickness of the resist was 600 nm. An image of a pattern of 200 nm-wide lines and spaces was introduced into the resist material using a conventional 248 nm projection lithography tool. The pattern was then developed using a conventional developer (Microdeposit 351; 1:5 dilution in water) for 40 seconds. The pattern was then transferred into the underlying layer of oxide using an oxygen plasma etch (RF voltage of 100 V, 50 mtorr CHF₃ at a flow rate of 50 sccm/min for 30 seconds). The depth of the transferred pattern was 100 nm. The remaining resist was removed using acetone.

The oxide pattern was then exposed to a vapor of tridecafluoro-1,1,2,2-tetrahydrooctyl-1-trichlorosilane. The wafer with the oxide pattern thereon was placed in a vacuum chamber and a few drops of silane were then introduced into the chamber.

A liquid precursor for polydimethylsiloxane (PDMS, obtained as Sylgard 184 from the Dow Chemical Co.) was then cast onto the patterned resist. The prepolymer was then cured (i.e. hardened) at 65°C for two hours. The cured PDMS film was then separated from the patterned resist.

The mold was then used to introduce a pattern into a layer of energy-sensitive material. Layers of a light-curable material, epoxy novolac (obtained as D.E.N. 431 from the Dow Chemical Company of Midland, Michigan) combined with an acrylate photosensitizer (3 percent by weight) were spin-cast onto two different substrates. One substrate was a silicon substrate on which were formed successive layers of oxidized silicon and tungsten. Another substrate was a silicon substrate on which was formed a gold layer. The material was spin-cast by diluting it with propylene glycol monomethyl ether acetate (8:1 by volume). The liquid mixture was spin-cast using a speed of 5000 rpm for about 40 seconds to produce a liquid film with a thickness of 200 nm. Consequently, the energy-curable film was thicker than the depth of the relief features in the mold.

The flexible mold was then placed in contact with the liquid film. The flexible mold was placed in contact in a manner that prevented air from being trapped between the mold and the liquid film. In one example, the center of the mold was first placed in contact with the center of the wafer, and the contact proceeded outward. In another example, one edge of the mold was placed in contact with one edge of the liquid film and progressive contact was made across the surface of the wafer.

The mold was then pressed into contact with the liquid using an optically flat surface. The apparatus used to press the flat surface in contact with the mold is illustrated schematically in FIG. 2. The liquid material was then hardened by exposing the material to ultraviolet radiation from an Oriel 68810 mercury arc lamp obtained from Oriel Instruments of Stratford, Connecticut. The lamp power was 4 W/cm² and the liquid material was exposed to radiation from the lamp for 15 minutes, which was adequate to cure the 200-nm thick film. The radiation was transmitted through the mold.

After the film was hardened, the optically flat surface was removed from contact with the mold and the mold was peeled from contact with the hardened material. The hardened surface was then subjected to an anisotropic etch. The selected etch expedient was an oxygen plasma formed using an RF voltage of 100 V, an O₂ pressure of 50 mtorr and an O₂ flow rate of 50 sccm/min for 30 seconds. This was adequate time to remove the thin regions of the patterned film without removing the thicker regions of the patterned film. The pattern was then transferred into the underlying substrate. In the example where the substrate was a silicon wafer on which successive layers of oxidized silicon and tungsten were formed, the pattern in the hardened material was transferred into the underlying tungsten and oxidized silicon layers using reactive ion etching in a CF₄ plasma. The etch was performed in a Plasma-Therm 790 Series plasma etch tool. The flow rate of the CF₄ was 50 sccm, the pressure in the plasma etch tool was 50 mtorr and the operational voltage was 80 volts. The duration of the plasma etch was about one minute.

In the example where the substrate was a silicon wafer on which a gold layer was formed, the pattern was transferred into the underlying layer using a wet potassium iodide etch. The etch rate was about 28 angstroms/second. The etchant was Gold Etchant type TFA, which is obtained commercially from the Transene Co., Inc., of Danvers, MA.

## Claims

1. A lithographic process for device fabrication comprising:
forming a layer of a material on a substrate;
placing a mold of a flexible material and having a mold surface that defines a pattern in contact with the material layer, wherein the mold surface has a patterning region having at least one protruding surface and at least one recessed surface, wherein the protruding surface and the recessed surface cooperate to define a pattern feature,
contacting the mold on a side opposite the mold surface with a flat surface of an object with sufficient force to cause the mold to conform to the flat surface;
hardening the material while the material remains in contact with the mold surface and the flat surface is in contact with the mold;
removing the mold from contact with the hardened material film,
wherein, prior to hardening the material, the mold surface contacts the material layer with sufficient pressure to cause the material layer to conform to the mold surface, thereby introducing a relief pattern in the material layer that conforms to the pattern in the mold surface, and wherein the relief pattern has a thin region which corresponds to the protruding surface of the mold surface and a thick region which corresponds to the recessed surface of the mold surface.

2. The process of claim 1 wherein the mold surface further comprises a planarizing region.

3. The process of claim 2 further comprising:
processing the relief pattern to remove the thin portion of the hardened material, thereby exposing the portion of the substrate underlying the thin portion of the hardened material.

4. The process of claim 2 wherein the material is an energy-curable material.

5. The process of claim 2 wherein the material is a thermoplastic material.

6. The process of claim 2 wherein the pattern feature has a dimension that is less than about 5 µm.

7. The process of claim 6 wherein the pattern feature has a dimension that is less than about 500 nm.

8. The process of claim 4 wherein the flat surface and the mold material are transparent to the exposing radiation.

9. The process of claim 2 wherein the flat surface is an optically flat surface.

10. The process of claim 2 wherein the relief surface has a plurality of surfaces in a plurality of planes substantially parallel to a plane defined by the substrate surface wherein the surface in each plane is substantially planar.

11. The process of claim 2 wherein the substrate is selected from the group consisting of semiconductor substrates, plastic substrates, glass substrates, and metallic phase-change substrates.

12. The process of claim 2 wherein the substrate has a topographic surface on which the layer of material is formed.
